# EUROPEAN PATENT APPLICATION

(11) **EP 4 344 366 A1**
(43) Date of publication of application: **27.03.2024**
(21) Application number: 21940548.7
(22) Date of filing: 02.12.2021
(51) Int. Cl.: H05K 5/02

(54) **ELECTRICAL DEVICE**

(30) Priority: 20.05.2021 CN 202121090998 U
(71) Applicant: Sungrow Power Supply Co., Ltd., Hefei, Anhui 230088 (CN)
(72) Inventor: SHEN, Zhanliang, Hefei, Anhui 230088 (CN); XING, Jun, Hefei, Anhui 230088 (CN)
(74) Representative: Epping - Hermann - Fischer
(86) International application number: PCT/CN2021/134977
(87) International publication number: WO 2022/242105

(57) **Abstract**

The present invention relates to the field of electrical technology, and in particular, an electrical device. The electrical device provided by the present invention comprises a box, an external device and an external handle; the external device is fixed outside the box; the external handle is provided on the external device; and the external handle is used for carrying the electrical device. By providing the external handle on the external device, the external handle does not occupy the space of the box, and the occupation area of the box after the mounting of the external handle is reduced, such that the box can be made smaller, and the cost of the box is reduced, thereby reducing the cost of the whole machine, and improving the market competitiveness of the electrical device.

## Description

The present application claims priority to Chinese Patent Application No. 202121090998.0, titled "ELECTRICAL APPARATUS", filed on May 20, 2021 with the China National Intellectual Property Administration, which is incorporated herein by reference in its entirety.

### FIELD

The present application relates to the field of electrical technology, and in particular to an electrical apparatus.

### BACKGROUND

As the power of an electrical apparatus such as an inverter and a combiner box increases, the electrical apparatus requires to be highly miniaturized. In order to facilitate the carrying of the electrical apparatus, a handle is generally arranged on the electrical apparatus. In the conventional technology, the handle is generally arranged externally on the back of a box and occupies a certain space on the back of the box, which increases the volume and the cost of the box.

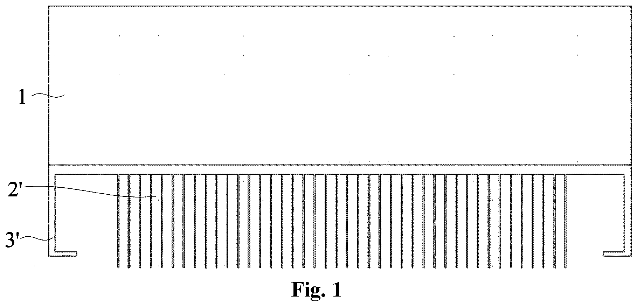

As shown in Figure 1, in another technical solution of the conventional technology, a handle and a radiator are arranged side by side on the back of the box. Since the radiator is attached to the box, the width of the box is generally greater than the width of the radiator for the sake of appearance. The handle increases the size of the box in the width direction, and also increases the volume and the cost of the box.

### SUMMARY

The object of present application is to provide an electrical apparatus, and an external handle does not additionally increase the space of the box, so as to reduce the cost of the box and improve the market competitiveness of the electrical apparatus.

In order to achieve the object, the following technical solutions are adopted in the present application.

An electrical apparatus includes:
a box;
an external device, fixed to an outer side of the box; and
an external handle, arranged on the external device, where the external handle is configured for carrying of the electrical apparatus.

By arranging the external handle on the external device, the external handle does not occupy additional space of the box, which reduces the occupation of the area of the box after the external handle is mounted, realizes a small box, and reduces the cost of the box, thereby reducing the cost of the entire electrical apparatus and improving the market competitiveness of the entire electrical apparatus.

In an embodiment, the external handle is detachably fixed to the external device.

When the external handle is damaged in the event of a failure, it is convenient to disassemble the external handle from the external device for maintenance and replace the external handle with a new external handle.

In an embodiment, the electrical apparatus further includes:
a fastener, where a first mounting hole is provided in the external handle, a second mounting hole is correspondingly provided in the external device, and the fastener is configured to sequentially pass through the first mounting hole and the second mounting hole to fix the external handle to the external device.

A detachable connection between the external handle and the external device is realized through the fastener, and is more stable and reliable.

In an embodiment, the external handle is fixed to the external device by bonding or welding.

The external handle and the external device are connected into an integrated structure, to prevent the external handle from falling off from the external device and enhance the stability and reliability of the connection between the external handle and the external device.

In an embodiment, the external device includes a first device and a second device arranged side by side, the number of the external handle is two, and the two external handles are symmetrically arranged on a side face of the first device and a side face of the second device.

By arranging the two external handles symmetrically on the external device, it is convenient for an operator to carry the electrical apparatus through the two external handles, thereby realizing a more convenient operation.

In an embodiment, a closed structure is enclosed by the external handle and the external device.

The operator holds the external handle in the closed structure without slipping out of the external handle, so that it is stable for holding the external handle and is stable and reliable for carrying the electrical apparatus.

In an embodiment, the external handle is U-shaped, and each of two side walls of the external handle is arranged on the external device.

The external handle is designed in a U-shape, which makes the structure simple and easy to realize, and ensures the closed structure enclosed by the external handle and the external device.

In an embodiment, an anti-skid rubber sleeve is sleeved on the external handle, and anti-skid is protrusions are provided on an outer surface of the anti-skid rubber sleeve.

The friction between the operator and the external handle can be increased by the anti-skid protrusions, avoiding slipping on the external handle and ensuring that the operator holds the external handle more stably and reliably. In addition, the anti-skid rubber sleeve and the anti-skid protrusions on the outer surface of the anti-skid rubber sleeve have a certain degree of elasticity, which can avoid rigid contact between the operator and the external handle, increase the comfort of the operator when holding the external handle, and improve the protection for a hand of the operator.

In an embodiment, anti-skid threads are provided on a circumferential surface of the external handle.

The friction between the operator and the external handle is increased, avoiding slipping on the external handle, thereby ensuring that the operator holds the external handle more stably and reliably.

In an embodiment, the external handle is made of metal.

The external handle is made of metal, which can prevent deformation of the external handle and ensure the service life of the external handle.

In an embodiment, the electrical apparatus is an inverter, and the external device is a radiator or a reactor.

The beneficial effects of the present application are as follows:

The electrical apparatus is provided according to the present application. The electrical apparatus includes the box, the external device and the external handle. The external device is fixed on the outer side of the box, and the external handle is arranged on the external device. The external handle is configured for carrying of the electrical apparatus. By arranging the external handle on the external device, the external handle does not occupy additional space of the box, which reduces the occupation of the area of the box after the external handle is mounted, realizes a small box and reduces the cost of the box, thereby reducing the cost of the entire electrical apparatus and improving the market competitiveness of the entire electrical apparatus.

### BRIEF DESCRIPTION OF THE DRAWINGS

Figure 1 is a schematic structural diagram of an electrical apparatus in the conventional technology;
Figure 2 is a schematic structural diagram of an electrical apparatus according to an embodiment of the present application; and
Figure 3 is a section view of a part of an electrical apparatus according to an embodiment of the present application.

Reference numerals in the drawings are as follows:

| | | | | | |
|---|---|---|---|---|---|
| 1 | box; | 2' | radiator; | 3' | handle; |
| 2 | external device; | 21 | first device; | 211 | second mounting hole; |
| 22 | second device; | 3 | external handle; | 31 | first mounting hole; |
| 4 | fastener. | | | | |

### DETAILED DESCRIPTION OF THE EMBODIMENTS

In order to clarify the technical problems solved, the technical solutions adopted, and the technical effects achieved by the present application, the technical solutions of the present application are further described below in conjunction with the accompanying drawings and through specific embodiments.

In the description of the present application, unless otherwise clearly specified and limited, terms "connect to", "connect", and "fix" should be understood in a broad sense, for example, may be a fixed connection, a detachable connection, or a connection to be integrated; may be a mechanical connection or an electric connection; may be a direct connection, or an indirect connection through an intermediary, and may be an internal connection of two components or an interaction relationship between two components. For those skilled in the art, the specific meanings of the terms in the present application can be understood based on specific situations.

In the present application, unless otherwise clearly specified and limited, a first feature being "on" or "under" a second feature may include the first feature directly contacting the second feature, and may also include the first feature not directly contacting the second feature but contacting through another feature between the first and second features. Moreover, the first feature being "on", "above" and "over" the second feature includes that the first feature is directly above and obliquely above the second feature, or simply indicates that the first feature is higher than the second feature in height with reference to a horizontal line. The first feature being "below", "under" and "beneath" the second feature includes that the first feature is directly below and obliquely below the second feature, or simply indicates that the first feature is lower than the second feature in height with reference to a horizontal line.

In the description of the embodiments, terms "up", "down", "left", "right" and other orientations or positional relationships are based on the orientations or positional relationships shown in the accompanying drawings, and are only for the convenience of description and simplification of operations, rather than indicating or implying that the device or element must have a specific orientation, be constructed and operated in a specific orientation, and thus should not be understood as a limitation of the present application. In addition, terms "first" and "second" are only used to distinguish in description and have no special meaning.

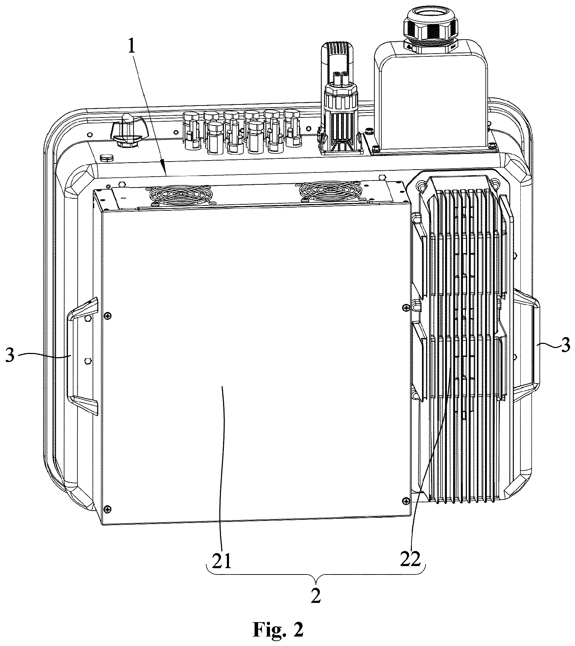

As shown in Figure 2, an electrical apparatus is provided according to an embodiment of the present application. The electrical apparatus may be an inverter or a combiner box, but is not limited to this, and may also be other electrical apparatuses.

Specifically, as shown in Figure 2, the electrical apparatus mainly includes a box 1 and an external device 2. The box 1 is configured to protect and support internal electrical components, and the external device 2 may be a reactor, a radiator, an air duct, or an assembly of a radiator and an air duct. The external device 2 is detachably fixed to the box 1, and is electrically connected to the electrical components inside the box 1, thereby achieving the corresponding function of the external device 2.

In an embodiment, as shown in Figure 2, in order to facilitate the carrying of the electrical apparatus, the electrical apparatus further includes an external handle 3. The external handle 3 can be configured for carrying of the electrical apparatus, and provide a force application point for carrying the electrical apparatus for easy operation.

However, in the conventional technology, a handle 3' is generally externally mounted on the back of a box 1 and occupies a certain space on the back of the box 1, which increases the volume and the cost of the box 1.

As shown in Figure 1, in another technical solution of the conventional technology, the handle 3' and a radiator 2' are arranged side by side on the back of the box 1. Since the radiator 2' is attached to the box 1, the width of the box 1 is generally larger than the width of radiator 2' for the sake of appearance. The handle 3' increases the size of the box 1 in the width direction, and also increases the volume and the cost of the box 1.

In order to solve the above problems, as shown in Figure 2, the external handle 3 according to the embodiment is arranged on the external device 2, so that the external handle 3 does not occupy additional space of the box 1, which reduces the occupation of the area of the box 1 after the external handle 3 is mounted, realizes a small box 1, and reduces the cost of the box 1, thereby reducing the cost of the entire electrical apparatus and improving the market competitiveness of the entire electrical apparatus.

In an embodiment, the external handle 3 is detachably fixed to the external device 2. When the external handle 3 is damaged, it is convenient to disassemble the external handle 3 from the external device 2 for maintenance and replace the external handle 3 with a new external handle 3.

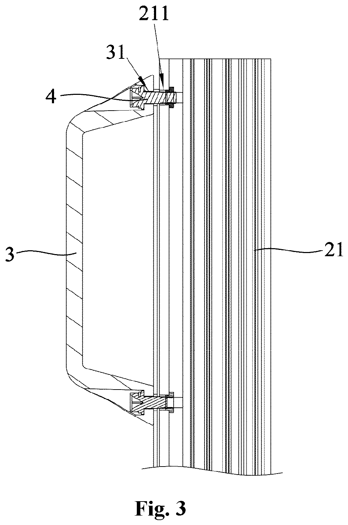

In an embodiment, as shown in Figure 3, the electrical apparatus further includes a fastener 4, and the fastener 4 is configured to detachably fix the external handle 3 to the external device 2. Specifically, a first mounting hole 31 is provided in the external handle 3, and a second mounting hole 211 is correspondingly provided in the external device 2. The fastener 4 is configured to sequentially pass through the first mounting hole 31 and the second mounting hole 211 to fix the external handle 3 to the external device 2, thereby realizing a detachable connection between the external handle 3 and the external device 2. The fastener 4 may be a bolt, and the bolt is detachably connected. In addition, the bolt has advantages of high reliability and low cost.

It should be noted that in other embodiments, alternatively, the external handle 3 may be detachably connected to the external device 2 through a nut. Specifically, the external device 2 passes through the first mounting hole 31 in the external handle 3. The external handle 3 is detachably connected to the external device 2 by screwing the nut on the external device 2 and abutting the nut against a side of the external handle 3.

In other embodiments, alternatively, the external handle 3 may be fixed to the external device 2 by bonding or welding, so that the external handle 3 and the external device 2 are connected as an integrated structure, avoiding the external handle 3 from falling off from the external device 2, and enhancing the stability and reliability of the connection between the external handle 3 and the external device 2.

In an embodiment, as shown in Figure 2, the external device 2 includes a first device 21 and a second device 22 arranged side by side. The number of the external handle 3 is two, and the two external handles 3 are arranged symmetrically on a side face of the first device 21 and a side face of the second device 22. By correspondingly arranging the two symmetrical external handles 3 on the external device 2, it is convenient for the operator to carry the electrical apparatus through the two external handles 3, thereby realizing a more convenient operation. It should be noted that multiple external handles 3 may be provided according to actual needs, and the number is not limited to two, and may be three, four, and so on.

In order to facilitate holding the external handle 3, as shown in Figure 2, a closed structure is enclosed by the external handle 3 and the external device 2. The operator holds the external handle 3 in the closed structure without slipping out of the external handle 3, so that it is stable for holding the external handle 3, and is stable and reliable for carrying the electrical apparatus.

In an embodiment, the external handle 3 is U-shaped, and each of two side walls of the external handle 3 is arranged on the external device 2, so that the structure of the external handle 3 is simple, which is convenient for processing and production, and the closed structure is enclosed by the external handle 3 and the external device 2.

In an embodiment, an anti-skid rubber sleeve is sleeved on the external handle 3, and anti-skid protrusions are provided on an outer surface of the anti-skid rubber sleeve. By arranging the anti-skid protrusions, the friction between the operator and the external handle 3 can be increased, avoiding slipping on the external handle 3, thereby ensuring that the operator holds the external handle 3 more stably and reliably. In addition, the anti-skid rubber sleeve and the anti-skid protrusions on the outer surface of the anti-skid rubber sleeve have a certain degree of elasticity, which can avoid rigid contact between the operator and the external handle 3, increase the comfort of the operator to hold the external handle 3, and improve the protection for a hand of the operator.

It should be noted that in other embodiments, anti-skid threads may be provided on a circumferential surface of the external handle 3, so as to increase the friction between the operator and the external handle 3, avoid slipping on the external handle 3, thereby ensuring that the operator holds the external handle 3 more stably and reliably.

In addition, in order to ensure the structural strength of the external handle 3, the external handle 3 is made of metal, which can prevent deformation of the external handle 3 and ensure the service life of the external handle 3.

Apparently, the embodiments of the present application are only examples for clearly illustrating the present application, and are not intended to limit the embodiments of the present application. For those skilled in the art, other variations or changes in different forms may be made based on the above description. It is not necessary and impossible to exhaustively list all the embodiments herein. Any modification, equivalent replacement, and improvement made within the spirit and principles of the present application shall be included within the protection scope of the claims of the present application.

## Claims

1. An electrical apparatus, comprising
a box (1);
an external device (2), fixed to an outer side of the box (1); and
an external handle (3), arranged on the external device (2), wherein the external handle (3) is configured for carrying of the electrical apparatus.

2. The electrical apparatus according to claim 1, wherein the external handle (3) is detachably fixed to the external device (2).

3. The electrical apparatus according to claim 2, further comprising:
a fastener (4), wherein a first mounting hole (31) is provided in the external handle (3), a second mounting hole (211) is correspondingly provided in the external device (2), and the fastener (4) is configured to sequentially pass through the first mounting hole (31) and the second mounting hole (211) to fix the external handle (3) to the external device (2).

4. The electrical apparatus according to claim 1, wherein the external handle (3) is fixed to the external device (2) by bonding or welding.

5. The electrical apparatus according to claim 1, wherein the external device (2) comprises a first device (21) and a second device (22) arranged side by side, the number of the external handle (3) is two, and the two external handles (3) are symmetrically arranged on a side face of the first device (21) and a side face the second device (22).

6. The electrical apparatus according to any one of claims 1 to 5, wherein a closed structure is enclosed by the external handle (3) and the external device (2).

7. The electrical apparatus according to claim 6, wherein the external handle (3) is U-shaped, and each of two side walls of the external handle (3) is arranged on the external device (2).

8. The electrical apparatus according to any one of claims 1 to 5, wherein an anti-skid rubber sleeve is sleeved on the external handle (3), and anti-skid protrusions are provided on an outer surface of the anti-skid rubber sleeve.

9. The electrical apparatus according to any one of claims 1 to 5, wherein anti-skid threads are provided on a circumferential surface of the external handle (3).

10. The electrical apparatus according to any one of claims 1 to 5, wherein the external handle (3) is made of metal.

11. The electrical apparatus according to claim 1, wherein the electrical apparatus is an inverter, and the external device (2) is a radiator or a reactor.
